# EUROPÄISCHE PATENTSCHRIFT

(11) **EP 1 478 674 B1**
(45) Veröffentlichungstag und Bekanntmachung des Hinweises auf die Patenterteilung: **21.06.2006**
(21) Anmeldenummer: 03714684.2
(22) Anmeldetag: 28.02.2003
(51) Int. Cl.: C08G 59/06, C08G 59/24, H01L 23/495

(54) **KORROSIONSARME EPOXYDHARZE UND HERSTELLUNGSVERFAHREN DAZU**
LOW-CORROSIVE EPOXY RESINS AND PRODUCTION METHOD THEREFOR
RESINES EPOXY PEU CORROSIVES ET PROCEDE DE FABRICATION

(30) Priorität: 28.02.2002 DE 10208743
(43) Veröffentlichungstag der Anmeldung: 24.11.2004
(73) Patentinhaber: SIEMENS AKTIENGESELLSCHAFT, 80333 München (DE)
(72) Erfinder: GRÖPPEL, Peter, 81058 Erlangen (DE)
(86) Internationale Anmeldenummer: PCT/DE2003/000715
(87) Internationale Veröffentlichungsnummer: WO 2003/072627

(56) Entgegenhaltungen:
- US-A- 4 668 807
- US-A- 5 098 965
- US-A- 5 783 713
- US-B1- 6 211 389
- PATENT ABSTRACTS OF JAPAN vol. 1996, no. 07, 31. Juli 1996 (1996-07-31) & JP 08 073563 A (NIPPON STEEL CHEM CO LTD), 19. März 1996 (1996-03-19)

## Beschreibung

Die Erfindung betrifft Epoxidharze mit extrem niedrigem Chlorgehalt, insbesondere niedrigem Gehalt an organisch gebundenem Chlor.

Epoxidharze haben ein weites Anwendungsspektrum in der Elektronik und Elektrotechnik. Sie finden Verwendung in Pressmassen, GlobTopmassen, Leiterplattenmaterialien, Klebstoffen, Underfillern und Folien und zur Abdeckung elektronischer und optoelektronischer Bauelemente. Als Basismaterialien dienen dabei häufig Bisphenol-A-diglycidylether und Bisphenol-F-diglycidylether. Diese werden in der Regel durch Umsetzung der entsprechenden Bisphenole mit Epichlorhydrin erhalten. Das bei der Synthese entstehende ionisch gebundene Chlorid kann durch wässrige Waschprozesse bis auf wenige ppm entfernt werden. Chlorhaltige organische Verbindungen, die als Nebenprodukte entstehen und einen Gesamtchlorgehalt der Epoxidverbindungen von bis zu 0,5 Gewichts-% bewirken, werden dagegen durch wässrige Aufarbeitung nicht entfernt. Epoxidharze wie z. B. Bisphenol-A-diglycidylether oder Bisphenol-F-diglycidylether mit einem Gesamtchlorgehalt kleiner 100 ppm sind bislang nicht bekannt.

Aus der US 3,413,320 ist die Aufreinigung von Epoxidharzen durch Umkristallisation auf Gesamtchlorwerte von ca. 0,37% beschrieben, diese geringe Verringerung des Chlorgehaltes zeigt jedoch erwartungsgemäß keinerlei Auswirkung auf das korrosive Verhalten der Epoxidharze.

Es wird allgemein angenommen, dass an Luft, insbesondere in Gegenwart von Wärme und Feuchtigkeit das organisch gebundene Chlor zumindest zum Teil in Chloridionen umgewandelt wird. Diese Ionen können Korrosion der mit ihnen in Berührung kommenden Teile verursachen.

Es besteht daher der Bedarf Epoxidharze zur Verfügung zu stellen, die einen geringen Restgehalt an Chlor, insbesondere an organisch gebundenem Chlor, enthalten und damit möglichst geringe Tendenz, Korrosion zu verursachen.

Aufgabe der Erfindung ist es daher, ein Epoxidharz, insbesondere einen Bisphenol-diglycidylether, zu schaffen, das nur noch über einen vernachlässigbaren Restgehalt an Chlor verfügt. Zudem ist es Aufgabe der Erfindung, ein Herstellungsverfahren dazu zur Verfügung zu stellen.

Gegenstand der Erfindung ist ein Epoxidharz, mit einem Gesamtgehalt an Chlor, organisch und/oder ionisch gebunden vorliegend, kleiner 100 ppm. Außerdem ist Gegenstand der Erfindung ein Verfahren zur Verminderung des Chlorgehaltes in Epoxidharzen, das sich dadurch auszeichnet, dass das Epoxidharz in fester Form in einem Lösungsmittel extrahiert wird.

Nach einer vorteilhaften Ausgestaltung der Erfindung kann der Chlorgehalt durch Extraktion des Harzes in einem Lösungsmittel gesenkt werden. Dabei liegt das Harz in Form fester Partikel vor. Bevorzugt ist, dass die Partikel, die zumindest in Teilbereichen auch kristallin vorliegen können, zuvor zerkleinert werden. Besonders bevorzugt können die Partikel durch eine geeignete Umfällung zerkleinert werden. Dazu wird das jeweilige Harz, bevorzugt unter Wärmezugabe, in einem dazu geeignetem Lösungsmittel gelöst, wobei sich beim Abkühlen feinste Tröpfchen in dem Lösungsmittel (Dispersion) ausbilden, die dann extrahiert werden, bis der Chlorgehalt entsprechend gefallen ist.

Unter Extraktion wird hier das Herauslösen bestimmter Bestandteile eines festen Stoffgemisches durch geeignete Lösungsmittel verstanden. Dabei läuft ein Diffusionsprozess ab, der durch die verschiedene Löslichkeit der Komponenten in dem Lösungsmittel initiiert wird.

Nach einer bevorzugten Ausführungsform des Verfahrens wird zur Extraktion als Lösungsmittel ein organisches Lösungsmittel wie z.B. ein Alkohol, bevorzugt ein monovalenter Alkohol und insbesondere bevorzugt Methanol und/oder Ethanol, auch beispielsweise in einem Gemisch mit Wasser, eingesetzt. Als Lösungsmittel eignet sich jedoch jedes andere Lösungsmittel und insbesondere auch ein Gemisch verschiedener Alkohole, Wasser und/oder Lösungsmittel. Der Begriff "Lösungsmittel" bezieht sich hier immer auch auf ein Lösungsmittel-Gemisch.

Nach einer vorteilhaften Ausführungsform wird das Harz zur Extraktion in einem Lösungsmittel gerührt, insbesondere bevorzugt mit Hilfe einer Dispergierscheibe.

Nach einer Ausführungsform wird unter Temperaturerhöhung extrahiert und/oder gerührt. Dabei ist zu beachten, dass das Epoxidharz bei der Temperatur noch fest bleibt und das Lösungsmittel nicht verdampft.

Die erfindungsgemäßen Harze wurden einer Elektro-Korrosionsprüfung einer Klebstoffformulierung an IPC (Integrated Plastic Circuit) Testboards unter folgenden Bedingungen unterzogen: 85°C bei 85% rel. Feuchte für die Dauer von 1000 Stunden.

Im folgenden wird die Erfindung anhand eines Herstellungsbeispiels und durchgeführter Korrosionsprüfungen von exemplarischen Ausführungsformen des erfindungsgemäßen Epoxidharzes wie einem Klebstoff, einer Formulierung für ein Leiterplattenlaminat, einem Gießharz und einem Underfiller noch näher beschrieben:

### Beispiel 1 :

Reinigung von Bisphenol-A-diglycidylether in Ethanol 50 g auskristallisiertes Bisphenol-A-diglycidylether (Epliox® A-17-04, Fa. Leuna-Harze) mit einem Gesamtchlorgehalt von 800 ppm wird in 50 g Ethanol (p.a. Fa. Aldrich) suspendiert und mit Hilfe eines Stabmixers für die Dauer von 60 Sekunden zerkleinert. Die Suspension wird in einem geschlossenen Gefäß für 17 Stunden mit Hilfe einer Dispergierscheibe gerührt. Dabei muss darauf geachtet werden, dass die Temperatur der Suspension nicht über 40 °C steigt. Danach wird das Gemisch im Wasserstrahlvakuum abfiltriert und mit wenig Lösungsmittel nachgewaschen und im Vakuumschrank getrocknet. Anschließend wird der Gesamtchlorgehalt mit Hilfe der Carbitol-Methode gemessen.

Dieser Vorgang wird 2 Mal wiederholt. Man erhält dabei ein Bisphenol-A-diglycidylether in 60 % Ausbeute mit einem Gesamtchlorgehalt von 80 ppm. (siehe Diagramm 1)

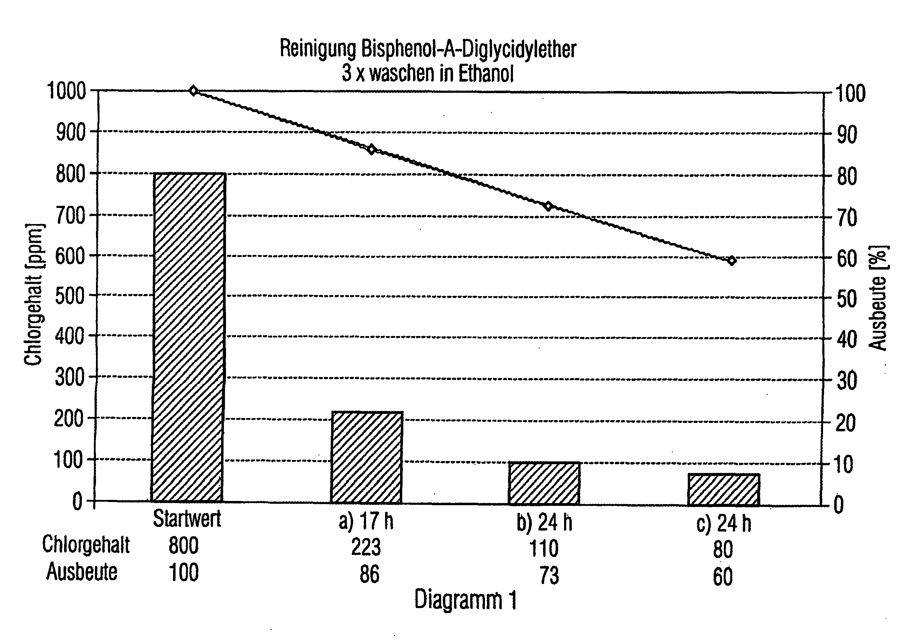

In Figur 1 ist im Diagramm gezeigt, wie der Chlorgehalt während der Extraktion sukzessive abnimmt.

### Beispiel 2:

E-Korrosionsprüfung einer Klebstoffformulierung an IPC-Testboards:
Prüflinge : 2 Stück IPC-Testboards mit Klebstoff beschichtet. Angewandte Prüfbestimmung : DIN EN 60068-2-67
Durchgeführte Prüfung : Klimaprüfung in 85°C bei 85 % rel. Feuchte, Dauer 1000 Stunden.
Prüfbedingungen : Die Testboards wurden während der gesamten Prüfdauer mit 100 Volt-DC belastet. Zur Untersuchung der Korrosion wird der Oberflächenwiderstand beim Unterschreiten eines Leckstromes von > 1mA oder < 10⁶ Ω zwischen benachbarten Kammmusterzungen mittels Lumi-Dioden angezeigt.

Zusammensetzung des Klebstoffs:
50 g Bisphenol-A-diglycidylether, aufgereinigt Gesamtchlorgehalt 42 ppm
50 g Bisphenol-F-diglycidylether, aufgereinigt Gesamtchlorgehalt 85 ppm
10,9 g Tetraethylendiamin
0,5 g 2-Methylimidazol
0,5 g Triethoxy-epoxypropylsilan

Ergebnis nach 1000 Stunden Test:
Visuell sind keine Anzeichen von Korrosion zu erkennen.
Es konnte keine signifikante Veränderung der Isolationswiderstände festgestellt werden.
Messung der Isolationswiderstände vor- bzw. nach der 1000-stündigen Klimalagerung ergaben keine signifikante Änderung der Widerstände.

### Beispiel 3:

### E-Korrosionsprüfung einer Formulierung für Leiterplattenlaminate an IPC-Testboards

Prüflinge : 2 Stück IPC-Testboards mit Formulierung für Leiterplattenlaminate beschichtet.
Angewandte Prüfbestimmung : DIN EN 60068-2-67
Durchgeführte Prüfung : Klimaprüfung in 85°C bei 85 % rel. Feuchte, Dauer 1000 Stunden.
Prüfbedingungen : Die Testboards wurden während der gesamten. Prüfdauer mit 100 Volt-DC belastet. Zur Untersuchung der Korrosion wird der Oberflächenwiderstand beim Unterschreiten eines Leckstromes von > 1mA oder < 10⁶ Ω zwischen benachbarten Kammmusterzungen mittels Lumi-Dioden angezeigt. Der Prüfaufbau ist in Bild 1 in Beispiel 2 dargestellt.
Zusammensetzung der Formulierung für Leiterplattenlaminate: 100 g Bisphenol-A-diglycidylether, aufgereinigt Gesamtchlorgehalt 90 ppm
   10,5 g Dicyandiamin
   0,5 g 2,4-Ethylmethylimidazol
Ergebnis nach 1000 Stunden Test: Visuell sind keine Anzeichen von Korrosion zu erkennen.
Es konnte keine signifikante Veränderung der Isolationswiderstände festgestellt werden.

### Beispiel 4:

### E-Korrosionsprüfung eines Gießharzes an IPC-Testboards

Prüflinge : 2 Stück IPC-Testboards mit Gießharz beschichtet Angewandte Prüfbestimmung : DIN EN 60068-2-67
Durchgeführte Prüfung : Klimaprüfung in 85°C bei 85 % rel. Feuchte, Dauer 1000 Stunden.
Prüfbedingungen : Die Testboards wurden während der gesamten Prüfdauer mit 100 Volt-DC belastet. Zur Untersuchung der Korrosion wird der Oberflächenwiderstand beim Unterschreiten eines Leckstromes von > 1mA oder < 10⁶ Ω zwischen benachbarten Kammmusterzungen mittels Lumi-Dioden angezeigt. Der Prüfaufbau ist in Bild 1 in Beispiel 2 dargestellt.

Zusammensetzung des Gießharzes:
100 g Bisphenol-F-diglycidylether, aufgereinigt Gesamtchlorgehalt 70 ppm
90 g Hexahydrophthalsäureanhydrid
0,4 g Dimethylbenzylamin
100 g Quarzgut
Ergebnis : Visuell sind keine Anzeichen von Korrosion zu erkennen.
Es konnte keine signifikante Veränderung der Isolationswiderstände festgestellt werden.

### Beispiel 5:

### E-Korrosionsprüfung eines Underfillers an IPC-Testboards

Prüflinge : 2 Stück IPC-Testboards mit Underfiller beschichtet.
Angewandte Prüfbestimmung : DIN EN 60068-2-67
Durchgeführte Prüfung : Klimaprüfung in 85°C bei 85 % rel. Feuchte, Dauer 1000 Stunden.
Prüfbedingungen : Die Testboards wurden während der gesamten Prüfdauer mit 100 Volt-DC belastet. Zur Untersuchung der Korrosion wird der Oberflächenwiderstand beim Unterschreiten eines Leckstromes von > 1mA oder < 10⁶ Ω zwischen benachbarten Kammmusterzungen mittels Lumi-Dioden angezeigt. Der Prüfaufbau ist in Bild 1 in Beispiel 2 dargestellt.

Zusammensetzung des Underfillers:
30 g Bisphenol-A-diglycidylether, aufgereinigt Gesamtchlorgehalt 30 ppm
30 g Bis-(epoxycyclohexyl)-methylcarboxylat
20 g Hexahydromethylphthalsäureanhydrid
80 g Quarzgut (sphärisch)
Ergebnis : Visuell sind keine Anzeichen von Korrosion zu erkennen.
Es konnte keine signifikante Veränderung der Isolationswiderstände festgestellt werden.

Durch den Einsatz von Bisphenol-A-diglycidylether und/oder Bisphenol-F-diglycidylether mit einem Gesamtchlorgehalt < 100 ppm in Pressmassen, GlobTopmassen, Leiterplattenmaterialien, Klebstoffen, Underfillern, Folien und zur Abdeckung elektronischer und optoelektronischer Bauelemente mit einem Gesamtchlorgehalt < 100 ppm ist es erstmals gelungen epoxyfunktionelle, aromatische Systeme zu formulieren die keinerlei Korrosion nach DIN EN 60068-2-67 selbst nach 1000 Stunden aufweisen.

Die Erfindung betrifft Epoxidharze mit extrem niedrigem Chlorgehalt, insbesondere niedrigem Gehalt an organisch gebundenem Chlor. Außerdem betrifft sie ein Herstellungsverfahren, bei dem durch Extraktion fester Epoxidharz-Partikel, gegebenenfalls nach vorheriger Zerkleinerung und/oder Umfällung, Gesamtchlorgehalte von kleiner 100ppm im Epoxidharz realisiert werden. Der Einsatz dieser chlorarmen Epoxidharze in der Elektronik und/oder Elektrotechnik, senkt die Korrosionsanfälligkeit der Komponenten erheblich.

## Patentansprüche

1. Epoxidharz, mit einem Gesamtgehalt an Chlor, organisch und/oder ionisch gebunden vorliegend, kleiner 100 ppm.

2. Epoxidharz, erhältlich durch Extraktion des festen Epoxidharzes in Lösungsmittel mit einem Gesamtgehalt an Chlor, organisch und/oder ionisch gebunden vorliegend, kleiner 100 ppm.

3. Verfahren zur Verminderung des Chlorgehaltes in Epoxidharzen, das sich **dadurch** auszeichnet, dass das Epoxidharz in fester Form in einem Lösungsmittel extrahiert wird.

4. Verfahren nach Anspruch 3, bei dem das Harz in fester, gegebenenfalls in teilkristalliner Form extrahiert wird.

5. Verfahren nach einem der Ansprüche 3 oder 4, bei dem die Kristalle zuvor zerkleinert werden.

6. Verfahren nach einem der Ansprüche 3 bis 5, bei dem als Lösungsmittel ein Alkohol und/oder ein Alkohol-Wassergemisch eingesetzt wird.

7. Verwendung eines Harzes mit einem Gesamtgehalt an Chlor, organisch und/oder ionisch gebunden vorliegend, kleiner 100 ppm in der Elektrotechnik und/oder zur Verminderung der Korrosionsanfälligkeit elektronischer und/oder elektrotechnischer Bauteile.

## Claims

1. Epoxy resin having a total chlorine content of less than 100ppm, said chlorine being present in organically and/or ionically bound form.

2. Epoxy resin obtainable by extracting the solid epoxy resin in the solvent with a total chlorine content of less than 100 ppm, with said chlorine being present in organically and/or ionically bound form.

3. Method for reducing the chlorine content in epoxy resins, **characterized in that** the epoxy resin is extracted in solid form in a solvent.

4. Method according to claim 3, wherein the resin is extracted in solid or if necessary in partially crystalline form

5. Method according to one of claims 3 or 4, wherein the crystals are comminuted beforehand.

6. Method according to one of claims 3 or 5 wherein an alcohol and/or alcohol-water mixture is used as a solvent.

7. Use of a resin with a total chlorine content, organically and/or ionically bound, of less than 100ppm, in electrical engineering and/or to reduce the susceptibility to corrosion of electronic and/or electrical engineering components.

## Revendications

1. Résine époxy ayant une teneur totale en chlore à liaison organique et/ou ionique inférieure à 100 ppm.

2. Résine époxy pouvant être obtenue par extraction d'une résine époxy solide, à l'aide d'un solvant, avec une teneur totale en chlore à liaison organique et/ou ionique inférieure à 100 ppm.

3. Procédé permettant de réduire la teneur en chlore de résines époxy, **se caractérisant par le fait que** la résine époxy sous forme solide est extraite à l'aide d'un solvant.

4. Procédé selon la revendication 3, dans lequel la résine est extraite sous forme solide, le cas échéant sous forme partiellement cristalline.

5. Procédé selon l'une des revendications 3 ou 4, dans lequel les cristaux sont d'abord broyés.

6. Procédé selon l'une quelconque des revendications 3 à 5, dans lequel on utilise, en tant que solvant, un alcool et/ou un mélange alcool-eau.

7. Utilisation d'une résine ayant une teneur totale en chlore, à liaison organique et/ou ionique, inférieure à 100 ppm, dans le domaine de l'électrotechnique et/ou pour réduire la sensibilité à la corrosion de composants électroniques et/ou électrotechniques.
